# EUROPEAN PATENT APPLICATION

(11) **EP 4 693 744 A1**
(43) Date of publication of application: **11.02.2026**
(21) Application number: 25732671.0
(22) Date of filing: 27.05.2025
(51) Int. Cl.: H01Q 5/335, H01Q 1/24, H05K 1/02, H04M 1/02

(54) **ELECTRONIC DEVICE COMPRISING ANTENNA**

(30) Priority: 26.06.2024 KR 20240083704; 29.08.2024 KR 20240116991
(71) Applicant: Samsung Electronics Co., Ltd, Suwon-si, Gyeonggi-do 16677 (KR)
(72) Inventor: KIM, Byungjoon, Suwon-si, Gyeonggi-do 16677 (KR); KO, Byungkuk, Suwon-si, Gyeonggi-do 16677 (KR); KIM, Sungsoo, Suwon-si, Gyeonggi-do 16677 (KR); KIM, Eungwon, Suwon-si, Gyeonggi-do 16677 (KR); LEE, Donghyeok, Suwon-si, Gyeonggi-do 16677 (KR); LEE, Wonho, Suwon-si, Gyeonggi-do 16677 (KR); JO, Kyunghwan, Suwon-si, Gyeonggi-do 16677 (KR)
(74) Representative: Walaski, Jan Filip
(86) International application number: PCT/KR2025/007167
(87) International publication number: WO 2026/005302

(57) **Abstract**

An electronic device according to an embodiment may include a conductive member which forms at least a part of a lateral face of the electronic device and radiates a signal of a designated frequency band. The conductive member may include a protrusion which projects toward an internal space of the electronic device. The electronic device may include a display disposed on at least a part of a front face of the electronic device, a nonconductive member disposed between a rear face of the electronic device and the display and coupled to the conductive member, and a printed circuit board disposed in the internal space of the electronic device. The nonconductive member may include a first recess onto which the protrusion of the conductive member is seated. The wireless communication circuit may feed the conductive member through at least part of a third face formed by a first face of the protrusion of the conductive member and a second face extending from the first recess of the nonconductive member.

## Description

### [Technical Field]

The disclosure relates to an electronic device including an antenna.

### [Background Art]

An electronic device having a communication function may provide a mobile communication service using an antenna. The antenna may be disposed in a partial region inside and/or outside a housing portion of the electronic device. The antenna may be formed in a pattern of a printed circuit board, may be disposed on a carrier as a plate type, or may be formed on a flexible printed circuit board to be positioned within the housing. As another method, the antenna may utilize a metallic mechanical part as a radiator, or utilize a metallic housing as a radiator.

The foregoing information may be provided as related art for the purpose of aiding understanding of the disclosure. No claim or determination is made as to whether any of the foregoing may be applied as the prior art in connection with the disclosure.

### [Disclosure of Invention]

### [Solution to Problem]

An electronic device according to an embodiment of the disclosure may include a conductive member which forms at least a part of a lateral face of the electronic device and radiates a signal of a designated frequency band. The conductive member may include a protrusion which projects toward an internal space of the electronic device. The electronic device may include a display disposed on at least a part of a front face of the electronic device. The electronic device may include a nonconductive member disposed between a rear face of the electronic device and the display and coupled to the conductive member. The electronic device may include a printed circuit board disposed in the internal space of the electronic device. The electronic device may include a wireless communication circuit disposed on the printed circuit board. The nonconductive member may include a first recess onto which the protrusion of the conductive member is seated. The wireless communication circuit may feed the conductive member through at least part of a third face formed by a first face of the protrusion of the conductive member and a second face extending from the first recess of the nonconductive member, to radiate the signal of the designated frequency band from the conductive member.

An electronic device according to an embodiment of the disclosure may include a conductive member for forming at least a part of a lateral face of the electronic device and radiating a signal of a designated frequency band. The conductive member may include a protrusion which projects toward an internal space of the electronic device. The electronic device may include a nonconductive member disposed between a front face of the electronic device and a rear face of the electronic device and coupled with the conductive member to secure the conductive member. The electronic device may include a printed circuit board including a wireless communication circuit which feeds the conductive member. The electronic device may include a memory for storing instructions. The electronic device may include one or more processors. The nonconductive member may include a first recess onto which the protrusion of the conductive member is seated. The instructions, when executed by the one or more processors, cause the electronic device to feed, at the wireless communication circuit, to the conductive member through a conductive sheet disposed on one face formed by the protrusion of the conductive member and a peripheral portion of the first recess of the nonconductive member.

### [Brief Description of Drawings]

FIG. 1 is a perspective view illustrating a front face of an electronic device according to an embodiment.
FIG. 2 is a perspective view of an electronic device of FIG. 1 viewed from the back according to an embodiment.
FIG. 3 is a diagram illustrating configurations of an electronic device for feeding a radio signal through a conductive member according to an embodiment.
FIG. 4A is a diagram illustrating arrangement of a conductive member and a nonconductive member according to an embodiment.
FIG. 4B is a cross-sectional view of a cross section C-C' of FIG. 4A according to an embodiment.
FIG. 5 is a front view of a conductive sheet according to an embodiment.
FIG. 6 is a rear view of a conductive sheet according to an embodiment.
FIG. 7 is a cross-sectional view of a cross section C-C' of FIG. 3 according to an embodiment.
FIG. 8 is a diagram illustrating at least one insertion portion on a printed circuit board to which a fixing portion of a conductive connection member is inserted according to an embodiment.
FIG. 9 is a perspective view of a conductive connection member according to an embodiment.
FIG. 10 is a diagram illustrating that a fixing portion of a conductive connection member is inserted into at least one insertion portion of a printed circuit board according to an embodiment.
FIG. 11 is a diagram illustrating that a conductive connection member is connected to a printed circuit board and a conductive member according to an embodiment.
FIG. 12 is a graph illustrating radiation performance of an antenna according to an embodiment.
FIG. 13 is a diagram illustrating an example of arrangement of a printed circuit board and a conductive connection member according to an embodiment.
FIG. 14 is a diagram illustrating an example of arrangement of a printed circuit board and a conductive connection member according to an embodiment.
FIG. 15 is a cross-sectional view illustrating an example of a position for arranging a feeding structure in an electronic device according to an embodiment.
FIG. 16 is a diagram illustrating examples of shaping and coupling a conductive member and a nonconductive member according to an embodiment.
FIG. 17 is a block diagram of an electronic device in a network environment according to an embodiment.

In relation to descriptions of the drawings, like or similar reference numerals may be used for like or similar components.

### [Mode for the Invention]

Hereinafter, various embodiments of the present invention are disclosed with reference to the attached drawings. However, it should be understood that this is not intended to limit the present invention to specific embodiments, and embraces various modifications, equivalents, and/or alternatives of embodiments of the disclosure.

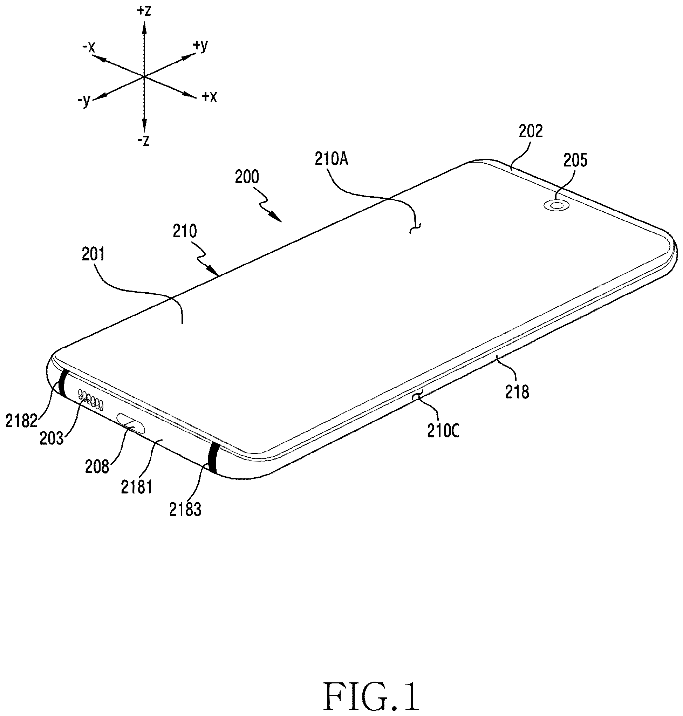

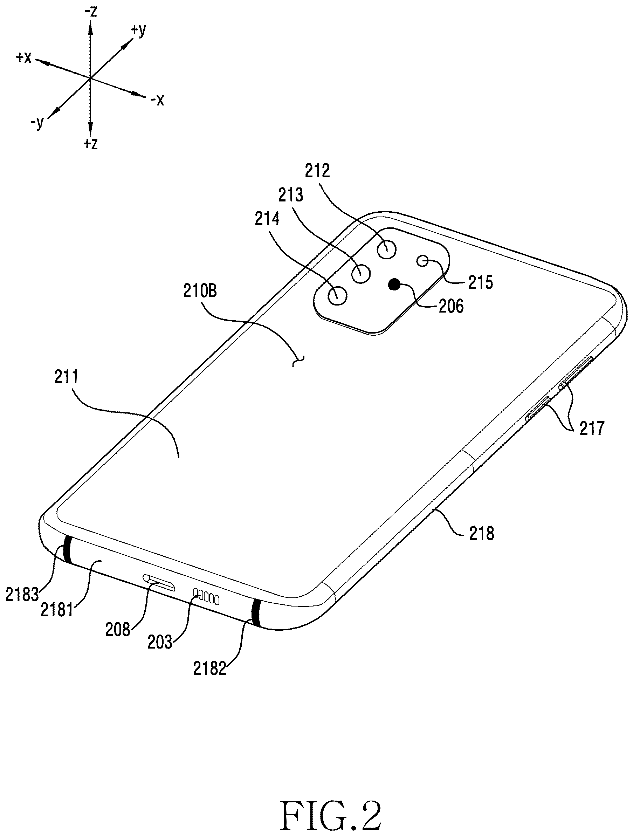

FIG. 1 is a perspective view illustrating a front face of an electronic device according to an embodiment, and FIG. 2 is a perspective view of the electronic device of FIG. 1 viewed from the back according to an embodiment.

Referring to FIG. 1 and FIG. 2, an electronic device 200 according to an embodiment may include a housing 210 which includes a first face (or a "front face") 210A, a second face (or a "rear face") 210B, and a lateral face (or a "side wall") 210C surrounding a space between the first face 210A and the second face 210B. In another embodiment (not shown), the housing 210 may indicate a structure which forms parts of the first face 210A, the second face 210B and the lateral face 210C of FIG. 2A and FIG. 2B.

According to an embodiment, the first face 210A may be formed by a front plate 202 (or, a "cover window) (e.g., a glass plate including various coating layers, or a polymer plate) which is at least in part substantially transparent. According to an embodiment, at least one side edge portion of the front plate 202 may include a curved portion which bends from the first face 210A and seamlessly extends toward a rear plate 211.

According to an embodiment, the second face 210B may be formed by the rear plate 211 which is substantially opaque. The rear plate 211 may be formed by, for example, coated or tinted glass, ceramic, polymer, metal (e.g., aluminum, stainless steel (STS), or magnesium), or a combination of at least two of those materials. According to an embodiment, at least one side edge portion of the rear plate 211 may include a curved portion which bends from the second face 210B and seamlessly extends toward the front plate 202.

According to an embodiment, the lateral face 210C may be coupled with the front plate 202 and the rear plate 211, and may be formed by a side member (or "a bracket") 218 including metal and/or polymer. In an embodiment, the rear plate 211 and the side member 218 may be integrally formed and include the same material (e.g., a metal material such as aluminum). In an example, the side member 218 may include a conductive portion 2181 and/or at least one nonconductive portion 2182 and 2183. For example, the first nonconductive portion 2182 may be disposed at one end (e.g., an end in the -x direction) of the conductive portion 2181, and the second nonconductive portion 2183 may be disposed at the other end (e.g., an end in the +x direction) of the conductive portion 2181 to electrically disconnect the conductive portion 2181. In another example, the conductive portion 2181 may be fed from a wireless communication circuit, to operate as an antenna radiator for transmitting and/or receiving a radio frequency (RF) signal of a designated frequency band.

According to an embodiment, the electronic device 200 may include at least one of a display 201, an audio module 203, a sensor module (not shown), camera modules 205, 212, 213, 214, 215, and 206, a key input device 217 or a connector hole 208. In an embodiment, the electronic device 200 may omit at least one (e.g., the key input device 217) of the components or additionally include other component.

In an embodiment, the electronic device 200 may further include a light emitting element, and the light emitting element may be disposed at a position adjacent to the display 201 within a region provided by the front plate 202. The light emitting element may provide, for example, state information of the electronic device 200 in the form of light. In another embodiment, the light emitting element may provide, for example, a light source interworking with an operation of the camera module 205. The light emitting element may include, for example, a light emitting diode (LED), an infrared (IR) LED and/or a xenon lamp.

According to an embodiment, the display 201 may be visible to outside of the electronic device 200 through a significant portion of the front plate 202. In an embodiment, an edge of the display 201 may be formed to be substantially identical to an outer peripheral shape (e.g., a curved face) adjacent to the front plate 202. In another embodiment (not shown), to expand the area exposing the display 201, a gap between an outer portion of the display 201 and an outer portion of the front plate 202 may be formed to be substantially identical. In another embodiment (not shown), the electronic device 200 may form a recess or an opening in a part of a screen display region of the display 201, and include other electronic component aligned with the recess or the opening, for example, the camera module 205, or a proximity sensor or an illuminance sensor not depicted.

In another embodiment (not shown), at least one of the camera modules 212, 213, 214, and 215, a fingerprint sensor (not shown), and a flash 206 may be disposed, on the rear face of the screen display region of the display 201. In yet an embodiment (not shown), the display 201 may be coupled with or disposed adjacent to a touch sensing circuit, a pressure sensor for measuring an intensity (pressure) of a touch, and/or a digitizer for detecting a magnetic stylus pen.

According to an embodiment, the audio module 203 may include a microphone hole and a speaker hole. A microphone for acquiring external sound may be disposed inside the microphone hole, and a plurality of microphones may be disposed to detect a sound direction in an embodiment. In an embodiment, the speaker hole and the microphone hole may be implemented as a single hole, or a speaker may be included without the speaker hole (e.g., a piezo speaker). The speaker hole may include an external speaker hole and/or a call receiver hole.

According to an embodiment, the electronic device 200, which includes the sensor module not shown, may generate an electrical signal or a data value corresponding to its internal operation state or an external environmental state. For example, the sensor module may further include a proximity sensor disposed on the first face 210A of the housing 210, a fingerprint sensor integrated with or disposed adjacent to the display 201 and/or a biometric sensor (e.g., a heart rate monitor (HRM) sensor) disposed on the second face 210B of the housing 210. The electronic device 200 may further include the sensor module not shown, for example, at least one of a gesture sensor, a gyro sensor, an air pressure sensor, a magnetic sensor, an acceleration sensor, a grip sensor, a color sensor, an IR sensor, a biosensor, a temperature sensor, a humidity sensor, or an illuminance sensor.

According to an embodiment, the camera modules 205, 212, 213, 214, 215, and 206 may include the first camera module 205 disposed on the first face 210A of the electronic device 200, and the second camera modules 212, 213, 214, and 215 and/or the flash 206 disposed on the second face 210B. In an example, the above camera modules 205, 212, 213, 214, 215, and 206 may include one or more lenses, an image sensor, and/or an image signal processor. In another example, the flash 206 may include a light emitting diode or a xenon lamp. In an embodiment, two or more lenses (an infrared camera, wide-angle and telephoto lenses) and image sensors may be disposed on one face of the electronic device 200.

According to an embodiment, the key input device 217 may be disposed in the lateral face 210C of the housing 210. In another embodiment, the electronic device 200 may not include a part or whole of the aforementioned key input device 217 and the key input device 217 not included may be implemented in a different form such as a soft key on the display 201. In an embodiment, the key input device may include at least a part of the fingerprint sensor disposed on the second face 210B of the housing 210.

According to an embodiment, the connector hole 208 may accommodate a connector for transmitting and receiving power and/or data to and from an external electronic device, and/or a connector for transmitting and receiving an audio signal to and from an external electronic device. For example, the connector hole 208 may include a universal serial bus (USB) connector or an earphone jack. In an embodiment, the USB connector and the earphone jack may be implemented as a single hole (e.g., 208 of FIG. 2A, FIG. 2B), and according to another embodiment (not shown), the electronic device 200 may transmit and receive power and/or data, or transmit and receive an audio signal to and from the external electronic device without a separate connector hole.

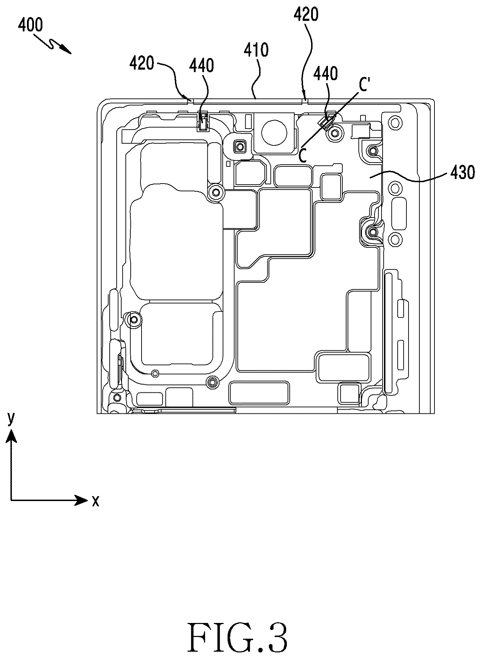

FIG. 3 is a diagram illustrating configurations for feeding a radio signal through a conductive member in an electronic device according to an embodiment.

According to an embodiment of the disclosure, an electronic device 400 may include a conductive member 410, a nonconductive member 420, a printed circuit board 430 and a conductive connection member 440. For example, the electronic device 400 may correspond to the electronic device 200 of FIG. 1 and FIG. 2. For example, the conductive member 410 may correspond to the conductive portion 2181 of the side member 218 of FIG. 1 and FIG. 2. For example, the nonconductive member 420 may correspond to the nonconductive portions 2182 and 2183 of the side member 218 of FIG. 1 and FIG. 2.

According to an embodiment of the disclosure, the conductive member 410 may form at least a part of a lateral face of the electronic device 400. The conductive member 410 may include a portion extending toward an internal space of the electronic device 400. For example, the conductive member 410 and the portion extending toward the internal space of the electronic device 400 may be formed integrally, or may be formed as separate members.

According to an embodiment of the disclosure, the nonconductive member 420 may be disposed in the internal space of the electronic device 400. For example, the nonconductive member 420 may be disposed between a rear face facing the -z-axis of the electronic device 400 and the display 201. For example, the display 201 may be disposed on at least a part of the front face facing the +z-axis of the electronic device 400. At least a part of the conductive member 410 may be coupled with the nonconductive member 420. For example, the nonconductive member 420 may be injection-molded and coupled with the conductive member 410.

According to an embodiment of the disclosure, by coupling at least a part of the nonconductive member 420 with the conductive member 410, the nonconductive member 420 may support the conductive member 410. According to an embodiment, since at least a part of the conductive member 410 is seated in the nonconductive member 420, at least a part of the conductive member 410 may be spaced away from the display 201 by a specific distance.

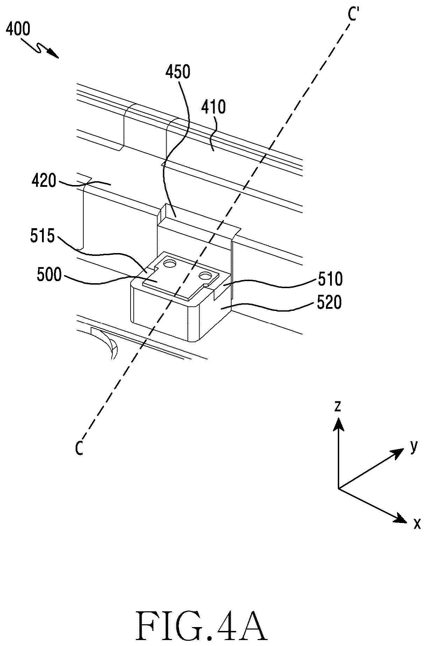

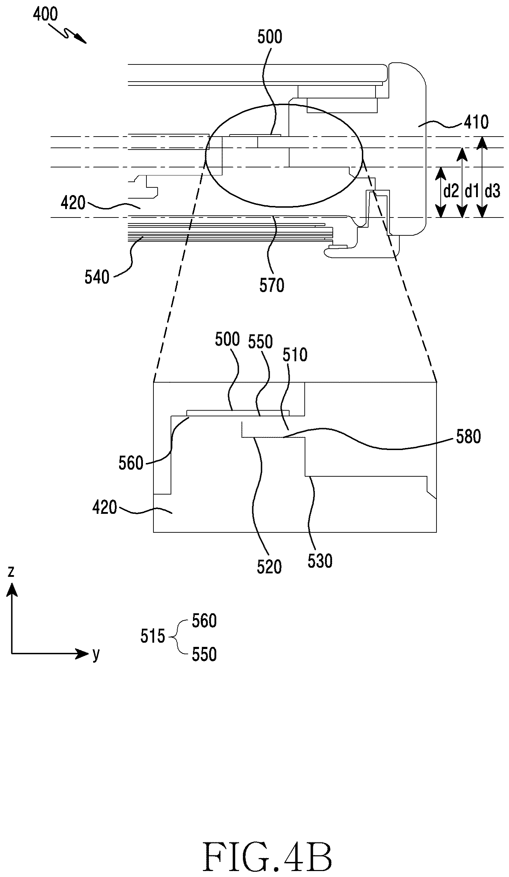

The structure in which the conductive member 410 is coupled with the nonconductive member 420 or the conductive member 410 is seated on the nonconductive member 420 shall be described in FIG. 4A and FIG. 4B.

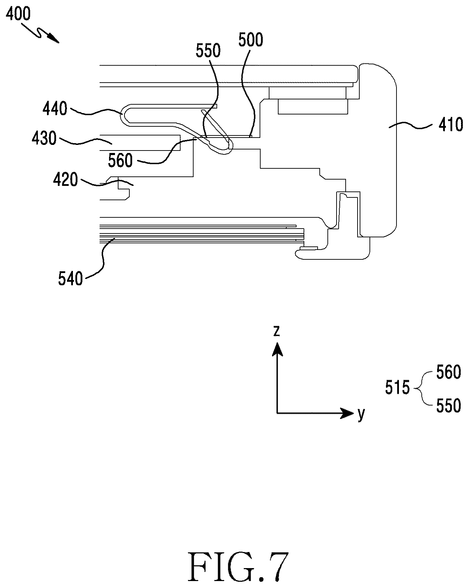

According to an embodiment of the disclosure, the printed circuit board 430 may be disposed in the internal space of the electronic device 400. The printed circuit board 430 may include a wireless communication circuit. For example, the wireless communication circuit may be disposed on one face of the printed circuit board 430. For example, the one face of the printed circuit board 430 may be a face facing the rear face of the electronic device 400. The wireless communication circuit may feed a signal of a designated frequency band to the conductive member 410. The conductive member 410 may radiate the signal received from the wireless communication circuit to the outside of the electronic device 400. For example, the conductive member 410 may be used as an antenna radiator for radiating a radio signal of the designated frequency band to the outside of the electronic device 400. The structure and the arrangement of the printed circuit board 430 shall be described in FIG. 7.

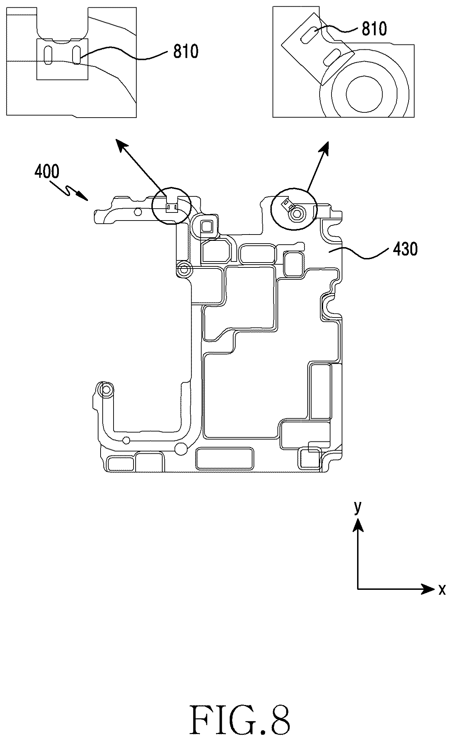

According to an embodiment of the disclosure, the conductive connection member 440 may forward the signal of the wireless communication circuit to the conductive member 410. One end of the conductive connection member 440 may be disposed on the printed circuit board 430. For example, one end of the conductive connection member 440 may be disposed on one face of the printed circuit board 430 on which the wireless communication circuit is disposed. The other end of the conductive connection member 440 may be disposed on at least a part of the conductive member 410. For example, the other end of the conductive connection member 440 may be positioned on at least a part of a portion of the conductive member 410 extending toward the internal space of the electronic device 400. The shape and the structure of the conductive connection member 440 shall be described in FIG. 8 through FIG. 10.

FIG. 4A is a diagram illustrating arrangement of a conductive member and a nonconductive member according to an embodiment. FIG. 4B is a cross-sectional view of a cross section C-C' of FIG. 4A according to an embodiment.

Referring to FIG. 4A and FIG. 4B, according to an embodiment of the disclosure, the conductive member 410 may include a protrusion 510. For example, the protrusion 510 of the conductive member 410 may include a portion extending from a lateral face of the electronic device 400 toward the internal space of the electronic device 400. For example, the protrusion 510 may be formed substantially perpendicular to the lateral face of the electronic device 400. The protrusion 510 of the conductive member 410 may include a first face 550 facing the -z-axis direction and a fifth face 580 facing the +z-axis direction.

According to an embodiment of the disclosure, the nonconductive member 420 may be disposed between the rear face of the electronic device 400 and a display 540. For example, the display 540 may be included in the display 310 of FIG. 1 and FIG. 2. At least a part of the nonconductive member 420 may be coupled with the conductive member 410. For example, the nonconductive member 420 may include a first recess 520 for coupling with the conductive member 410. For example, the protrusion 510 of the conductive member 410 may be inserted into at least a part of the nonconductive member 420 through an opening 450 of the nonconductive member 420. As the protrusion 510 of the conductive member 410 is inserted into the opening 450 of the nonconductive member 420, the protrusion 510 of the conductive member 410 may be seated on the first recess 520 of the nonconductive member 420. For example, the fifth face 580 facing the +z-axis of the protrusion 510 of the conductive member 410 may contact at least a part of the first recess 520. For example, the first recess 520 and the opening 450 may be formed by injecting the nonconductive member 420 onto the conductive member 410. For example, the first recess 520 and the opening 450 may be formed in a shape corresponding to the shape of the protrusion 510, by injecting the nonconductive member 420 onto the conductive member 410.

According to an embodiment of the disclosure, at least a part of the protrusion 510 of the conductive member 410 may be exposed in the internal space of the electronic device 400. For example, the protrusion 510 of the conductive member 410 may be exposed at least in part to the internal space of the electronic device 400, while seating on the first recess 520 of the nonconductive member 420.

According to an embodiment of the disclosure, the nonconductive member 420 may include a second face 560 extending from the first recess 520. For example, the second face 560 of the nonconductive member 420 may be a face facing in the +z-axis direction. The first face 550 of the protrusion 510 and the second face 560 of the nonconductive member 420 may form one face. For example, the first face 550 of the protrusion 510 and the second face 560 of the nonconductive member 420 may form one face, thus forming a third face 515.

According to an embodiment of the disclosure, a length of the protrusion 510 protruding toward the internal space of the electronic device 400 may be shorter than a longitudinal length of the second face 560 extending from the first recess 520 of the nonconductive member 420. For example, the longitudinal length of the second face 560 may be a length extending in the y-axis direction. For example, when viewing the protrusion 510 and the second face 560 extending from the first recess 520 from the z-axis direction, the length extending in the y-axis direction of the protrusion 510 may be shorter than the length extending in the y-axis direction of the second face 560.

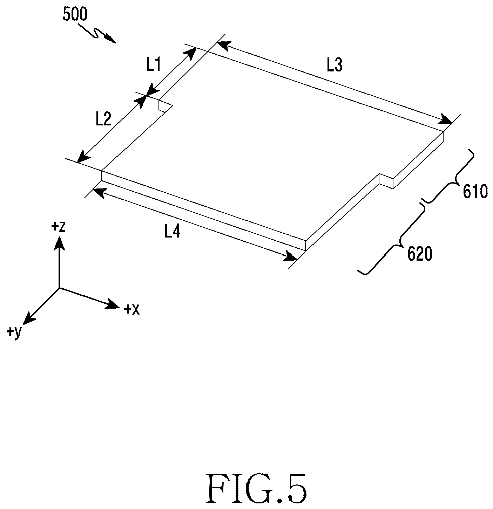

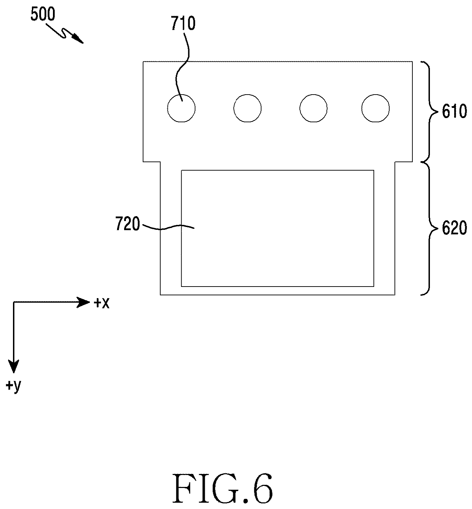

According to an embodiment of the disclosure, a conductive sheet 500 may be disposed on at least a part of the third face 515 formed by the first face 550 of the protrusion 510 and the second face 560 of the nonconductive member 420. The wireless communication circuit may feed to the conductive member 410 through the conductive sheet 500 connected to the conductive connection member 440. The shape and the arrangement of the conductive sheet 500 shall be described in FIG. 5 and FIG. 6.

According to an embodiment of the disclosure, the nonconductive member 420 may include a second recess 530 which forms a step from the first recess 520. For example, a portion of the conductive member 410 adjacent to the protrusion 510 of the conductive member 410 may be seated on the second recess 530 of the nonconductive member 420. Since the portion of the conductive member 410 adjacent to the protrusion 510 of the conductive member 410 is seated on the second recess 530 of the nonconductive member 420, the nonconductive member 420 may support the conductive member 410.

According to an embodiment of the disclosure, the electronic device 400 may further include the display 540. For example, the display 540 may correspond to the display 201 of FIG. 1 and FIG. 2. The display 540 may be disposed on at least a part of the front face facing the +z-axis direction of the electronic device 400.

According to an embodiment of the disclosure, the nonconductive member 420 may include a fourth face 570 facing the display 540. For example, the fourth face 570 may be a face facing the +z-axis direction. A distance d1 from the display 540 to the fifth face 580 of the protrusion 510 of the conductive member 410 may be greater than a distance d2 from the display 540 to the portion of the protrusion 510 adjacent to the protrusion 510 of the conductive member 410. For example, the distance between the display 540 and the first protrusion 510 may be greater than the distance between the display 540 and the conductive member 410. As the first protrusion 510 of the conductive member 410 is positioned farther from the display 540 than other portions of the conductive member 410, a signal of the wireless communication circuit fed to the conductive member 410 may receive less interference from the display 540.

According to an embodiment of the disclosure, a distance d3 between the display 540 and the conductive sheet 500 may be greater than the distance d1 between the display 540 and the fifth face 580 of the protrusion 510. For example, the distance between the display 540 and the conductive sheet 500 may be greater than the distance between the display 540 and the fifth face 580 of the protrusion 510. Since the wireless communication circuit feeds the signal to the conductive member 410 through the conductive sheet 500 disposed on at least a part of the first face 550 of the protrusion 510, the fed signal may receive less interference from the display 540.

FIG. 5 is a front view of a conductive sheet according to an embodiment. FIG. 6 is a rear view of a conductive sheet according to an embodiment.

According to an embodiment of the disclosure, the conductive sheet 500 may include a first portion 610 and a second portion 620. The first portion 610 of the conductive sheet 500 may be disposed on at least a part of the first face 550 of the protrusion 510 of the conductive member 410. For example, the first portion 610 of the conductive sheet 500 may be welded and attached to the first face 550 of the protrusion 510 of the conductive member 410. For example, the first portion 610 of the conductive sheet 500 may include a plurality of openings 710 to be welded to the first face 550 of the first protrusion 510 of the conductive member 410. The plurality of openings 710 may be formed in a direction facing the +z-axis of the first portion 610 of the conductive sheet 500. For example, the plurality of openings 710 may be formed to align on a rear face of the first portion 610 along a transverse direction of the conductive sheet 500.

According to an embodiment of the disclosure, the second portion 620 of the conductive sheet 500 may be disposed on at least a part of the second face 560 of the nonconductive member 420. For example, the second portion 620 of the conductive sheet 500 may be attached onto the second face 560 of the nonconductive member 420 by an adhesive member 720. For example, the adhesive member 720 may include an adhesive tape. At least a part of the rear face of the second portion 620 of the conductive sheet 500 may be attached onto at least a part of the second face 560 of the nonconductive member 420 by the adhesive member 720.

According to an embodiment of the disclosure, the second portion 620 of the conductive sheet 500 may be a portion extending from the first portion 610 toward the +y-axis direction of the conductive sheet 500. For example, a second length L2 of the second portion 620 may be longer than a first length L1 of the first portion 610. For example, the second portion 620, which is disposed on the nonconductive member 420, may have the adhesion for adhering the conductive sheet 500 to the nonconductive member 420, by forming the conductive sheet 500 such that the second length L2 of the second portion 620 is equal to or longer than the first length L1 of the first portion 610.

According to an embodiment of the disclosure, the length of the protrusion 510 of the conductive member 410 protruding toward the internal space of the electronic device 400 may be shorter than the length extending in the y-axis direction of the second face 560 of the nonconductive member 420. Hence, the first length L1 of the first portion 610 of the conductive sheet 500 attached to the protrusion 510 of the conductive member 410 may be shorter than the second length L2 of the second portion 620. To increase the adhesion of adhering the first portion 610 onto the first face 550 of the protrusion 510 of the conductive member 410, a third length L3 of the first portion 610 may be formed longer than a fourth length L4 of the second portion 620.

FIG. 7 is a cross-sectional view of a cross section C-C' of FIG. 3 according to an embodiment. For example, FIG. 7 may be the cross-sectional view of the electronic device 400 which further includes the printed circuit board 430 and the conductive connection member 440 of FIG. 4B.

According to an embodiment of the disclosure, the printed circuit board 430 may be disposed in the internal space of the electronic device 400. For example, the printed circuit board 430 may be disposed substantially parallel to the second face 560 extending from the first recess 520 of the nonconductive member 420 and/or the first face 550 of the first protrusion 510 of the conductive member 410. For example, the printed circuit board 430 may be disposed substantially parallel to the third face 515 formed by the first face 550 of the protrusion 510 of the conductive member 410 and the second face 560 of the nonconductive member 420. For example, one face of the printed circuit board 430 on which the wireless communication circuit is disposed may be arranged parallel to the third face 515.

According to an embodiment of the disclosure, FIG. 7 depicts that, but not limited to, at least a part of the printed circuit board 430 does not overlap the first protrusion 510 of the conductive member 410, when viewing the printed circuit board 430 from the lateral face of the electronic device 400. For example, when viewing the printed circuit board 430 from the lateral face of the electronic device 400, at least a part of the printed circuit board 430 may be disposed to overlap the first protrusion 510 of the conductive member 410. For example, when viewing the printed circuit board 430 from the lateral face of the electronic device 400, at least a part of the printed circuit board 430 may be disposed to overlap the first recess 520 of the nonconductive member 420.

According to an embodiment of the disclosure, the conductive sheet 500 may be disposed on at least a part of the first face 550 of the first protrusion 510 of the conductive member 410 and at least a part of the second face 560 of the nonconductive member 420. For example, the first portion 610 of the conductive sheet 500 may be attached to at least a part of the first face 550 of the first protrusion 510 of the conductive member 410. For example, the second portion 620 of the conductive sheet 500 may be attached to at least a part of the second face 560 of the nonconductive member 420.

According to an embodiment of the disclosure, one end of the conductive connection member 440 may be disposed on the printed circuit board 430. The other end of the conductive connection member 440 may be disposed on at least a part of the conductive sheet 500. For example, the other end of the conductive connection member 440 may be disposed on the front face of the conductive sheet 500. The front face of the conductive sheet 500 may be a face facing the rear face of the electronic device 400. For example, the shape of the conductive connection member 440 and its connection relationship with the printed circuit board 430 and the conductive sheet 500 shall be described in FIG. 8 through FIG. 11.

According to an embodiment of the disclosure, the wireless communication circuit disposed on one face of the printed circuit board 430 may be electrically connected to the conductive sheet 500 through the conductive connection member 440. The wireless communication circuit may transmit a signal of a designated frequency band to the conductive sheet 500 via the conductive connection member 440. The signal transmitted to the conductive sheet 500 may be fed to the conductive member 410 via the first protrusion 510 of the conductive member 410. The signal fed to the conductive member 410 may be radiated to the outside of the electronic device 400.

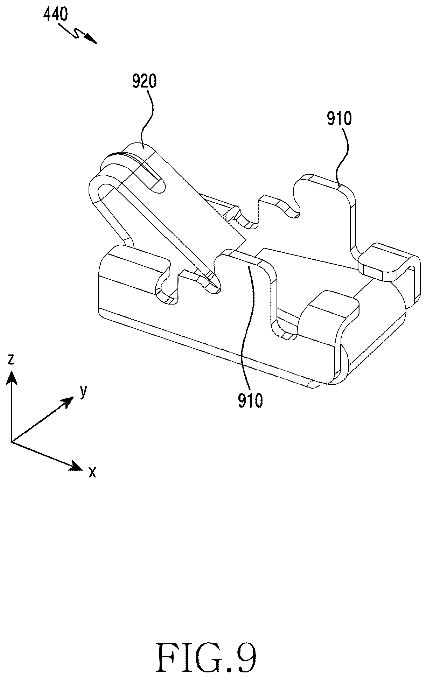

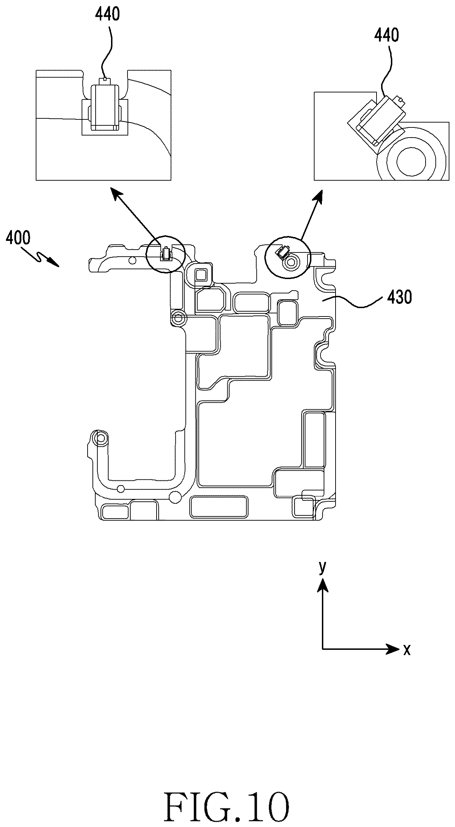

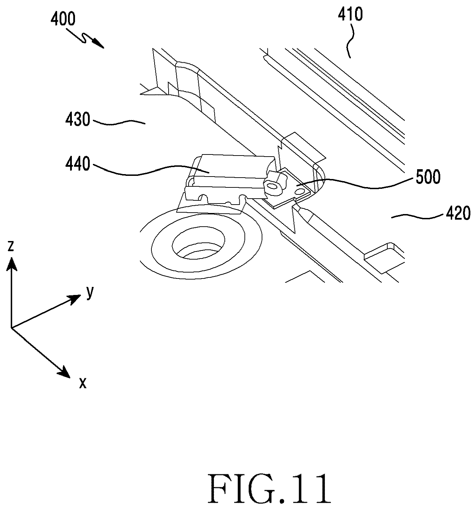

FIG. 8 is a diagram illustrating at least one insertion portion on a printed circuit board for inserting a fixing portion of a conductive connection member according to an embodiment. FIG. 9 is a perspective view of a conductive connection member according to an embodiment. FIG. 10 is a diagram illustrating that a fixing portion of a conductive connection member is inserted into at least one insertion portion of a printed circuit board according to an embodiment. FIG. 11 is a diagram illustrating that a conductive connection member is connected to a printed circuit board and a conductive member according to an embodiment.

Referring to FIG. 8, according to an embodiment of the disclosure, the printed circuit board 430 may include at least one insertion portion 810. For example, the at least one insertion portion 810 may be formed on at least a part of the printed circuit board 430 adjacent to the protrusion 510 of the conductive member 410. By inserting one side of the conductive connection member 440 into the at least one insertion portion 810 of the printed circuit board 430, the conductive connection member 440 may be electrically connected to the printed circuit board 430. The wireless communication circuit disposed on one face of the printed circuit board 430 may feed a signal of a designated frequency band to the conductive member 410 through the conductive connection member 440.

Referring to FIG. 9, according to an embodiment of the disclosure, the conductive connection member 440 may include at least one fixing portion 910 and a connection portion 920. For example, the at least one fixing portion 910 may be formed on one region of the conductive connection member 440. For example, the connection portion 920 may be formed on another region of the conductive connection member 440. The at least one fixing portion 910 of the conductive connection member 440 may protrude toward the +z-axis direction.

Referring to FIG. 10, according to an embodiment of the disclosure, by inserting the protruding at least one fixing portion 910 into the insertion portion 810 of the printed circuit board 430, the conductive connection member 440 may be secured to the printed circuit board 430, to be electrically connected to the printed circuit board 430.

Referring to FIG. 11, according to an embodiment of the disclosure, the connection portion 920 of the conductive connection member 440 may be electrically connected to the conductive member 410. For example, at least a part of the connection portion 920 may contact the conductive sheet 500 disposed on at least a part of the protrusion 510 of the conductive member 410 and the second face 560 extending from the first recess 520 of the nonconductive member 420. Since at least a part of the connection portion 920 contacts the conductive sheet 500, the conductive connection member 440 may be electrically connected to the conductive member 410.

According to an embodiment of the disclosure, with at least a part of the connection portion 920 of the conductive connection member 440 contacting the conductive sheet 500, as the at least one fixing portion 910 of the conductive connection member 440 is inserted into the at least one insertion portion 810 of the printed circuit board 430, the connection portion 920 of the conductive connection member 440 may be compressed. As the connection portion 920 of the conductive connection member 440 is compressed, the conductive connection member 440 may be electrically connected to the conductive sheet 500.

According to an embodiment of the disclosure, the conductive connection member 440, the conductive sheet 500, and the conductive member 410 may form an antenna for radiating the signal of the designated frequency band to the outside of the electronic device 400.

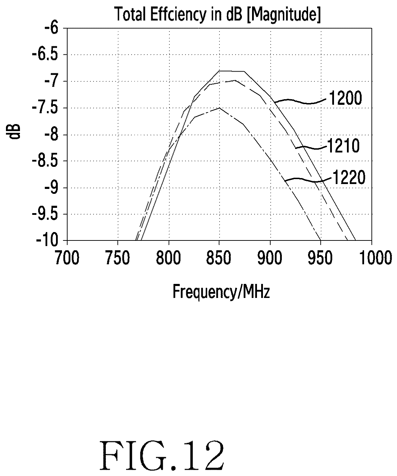

FIG. 12 is a graph illustrating radiation performance of an antenna according to an embodiment.

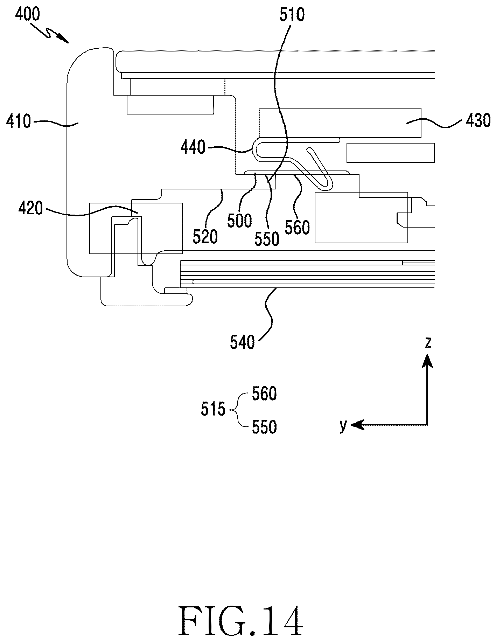

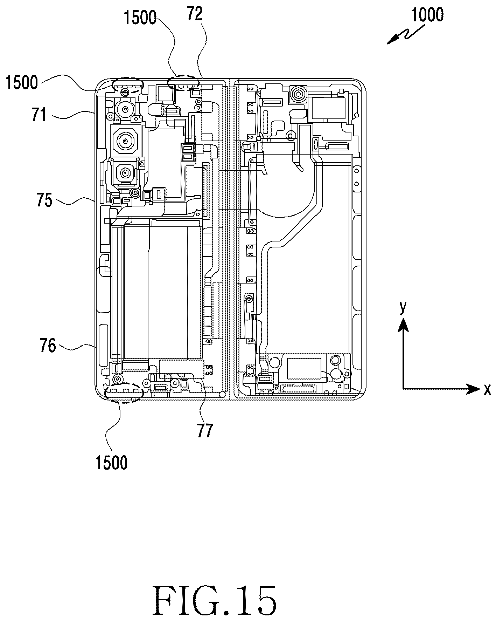

Referring to FIG. 12 according to an embodiment of the disclosure, for example, a reference numeral 1200 may be a graph representing the radiation performance of the antenna which radiates a radio signal through the first feeding structure of FIG. 1 through FIG. 11. For example, a reference numeral 1210 may be a graph representing the radiation performance of the antenna which radiates a radio signal through the second feeding structure of FIG. 14 and FIG. 15. For example, a reference numeral 1220 may be a graph representing the radiation performance of the antenna which radiates a radio signal through a feeding structure according to a comparative example.

According to an embodiment of the disclosure, referring to the reference numerals 1200, 1210 and 1220 of FIG. 12, radiation efficiency through the antennas of the first feeding structure and the second feeding structure in a 850 MHz frequency band may be higher than radiation efficiency through the antenna of the feeding structure according to the comparative example. In addition, frequency band widths of the first feeding structure and the second feeding structure may be greater than a frequency band width of the feeding structure according to the comparative example by about 30 MHz or more.

Referring to FIG. 12, for example, in the first feeding structure, since the wireless communication circuit disposed on the upper face of the printed circuit board 430 feeds the radio signal to the protrusion 510 of the conductive member 410 formed at a position spaced apart from the display 540 over a specific distance, the radio signal may receive less interference from the display 540 than in the feeding structure of the comparative example.

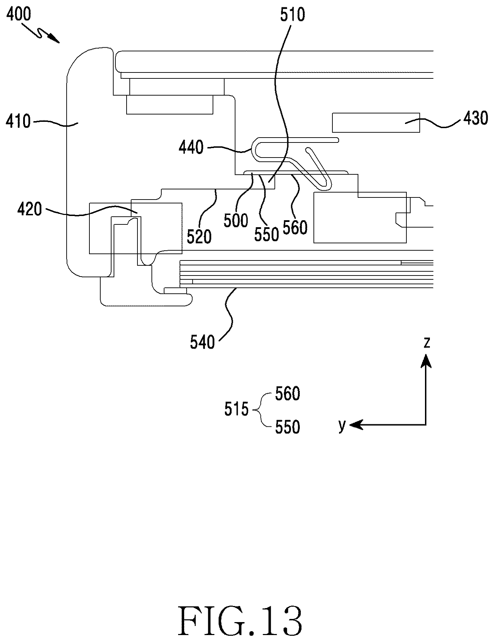

FIG. 13 and FIG. 14 are diagrams illustrating an arrangement example of a printed circuit board and a conductive connection member according to an embodiment.

According to an embodiment of the disclosure, referring to FIG. 13, when viewing the protrusion 510 of the conductive member 410 from the front face of the electronic device 400, at least a part of the conductive connection member 440 may overlap the protrusion 510. For example, when viewing the protrusion 510 and the first recess 520 from the front face of the electronic device 400, at least a part of the conductive connection member 440 may overlap the protrusion 510, and the remaining portion may overlap the second face 560 of the first recess 520.

According to an embodiment of the disclosure, referring to FIG. 13, a face of the printed circuit board 430 facing the front face of the electronic device 400 may be electrically connected to the conductive sheet 500 disposed on the third face 515 by the conductive connection member 440. For example, one end of the conductive connection member 440 may contact the face of the printed circuit board 430 facing the front face of the electronic device 400. For example, the other end of the conductive connection member 440 may contact the conductive sheet 500.

According to an embodiment of the disclosure, referring to FIG. 14, when viewing the printed circuit board 430 from the front face of the electronic device 400, at least a part of the printed circuit board 430 may overlap the second face 560 of the nonconductive member 420. For example, for example, at least a part of the face of the printed circuit board 430 facing the front face of the electronic device 400 may be disposed to face the second face 560 of the nonconductive member 420. For example, at least a part of the face of the printed circuit board 430 facing the front face of the electronic device 400 may be disposed to face the second portion 620 of the conductive sheet 500 disposed on at least a part of the second face 560.

According to an embodiment of the disclosure, referring to FIG. 14, the face of the printed circuit board 430 facing the back (the face facing the -z-axis direction) of the electronic device 400 may be electrically connected by the conductive connection member 440 to the conductive sheet 500 disposed on the third face 515 formed by the first face 550 of the first protrusion 510 and the second face 560 extending from the first recess 520. For example, one end of the conductive connection member 440 may be disposed on the face of the printed circuit board 430 facing the back (the face facing the -z-axis direction) of the electronic device 400. For example, the other end of the conductive connection member 440 may be disposed on the conductive sheet 500.

The arrangement of the conductive member 410, the nonconductive member 420, the printed circuit board 430, the conductive connection member 440 and the conductive sheet 500 is not limited to FIG. 13 and FIG. 14, and may be appropriately modified in such an extent that the signal fed from the wireless communication circuit to the conductive member 410 is not affected by the display 540.

FIG. 15 is a cross-sectional view illustrating an example of a position for arranging a feeding structure in an electronic device according to an embodiment.

According to an embodiment of the disclosure, the feeding structure may indicate a structure in which the wireless communication circuit disposed on the printed circuit board 430 described above in FIG. 1 through FIG. 14 feeds a signal of the designated frequency band to the protrusion 510 of the conductive member 410 through the conductive connection member 440.

Referring to FIG. 15, at least a part of a lateral portion of an electronic device 1000 may include a conductive member 410, and the conductive member 410 may operate as an antenna radiator for the wireless communication. For example, the electronic device 1000 may include a sub 1 antenna 71, a sub 2 antenna 72, a sub 4 antenna 75, and a main 1 antenna 76 formed on the lateral portion of the electronic device 1000. In addition, for example, the electronic device 1000 may include a main 3 antenna 77 disposed inside the electronic device 1000.

According to an embodiment, the sub 1 antenna 71 and the sub 2 antenna 72 may be used for satellite communications. For example, the sub 1 antenna 71 may be connected to a diversity receive (DRX) module for the satellite communications and used for receiving a satellite communication signal, and the sub 2 antenna 72 may be connected to a primary receive (PRX) module for the satellite communications and used for receiving a satellite communication signal.

According to an embodiment, the sub 4 antenna 75, the main 1 antenna 76 and the main 3 antenna 77 may be used for cellular communications. For example, the sub 4 antenna 75 may be connected to a middle high band (MHB) DRX multiple input multiple output (MIMO) module for cellular communications and used for receiving a cellular communication signal, the main 1 antenna 76 may be connected to a MB PRX MIMO module for cellular communications and used for receiving a cellular communication signal, and the main 3 antenna 77 may be connected to a HB PRX MIMO module for the cellular communications and used for receiving a cellular communication signal.

FIG. 15 illustrates at least some of the antennas disposed on the electronic device 1000, and the type and the position of the antennas disposed on the electronic device 1000 are not limited thereto.

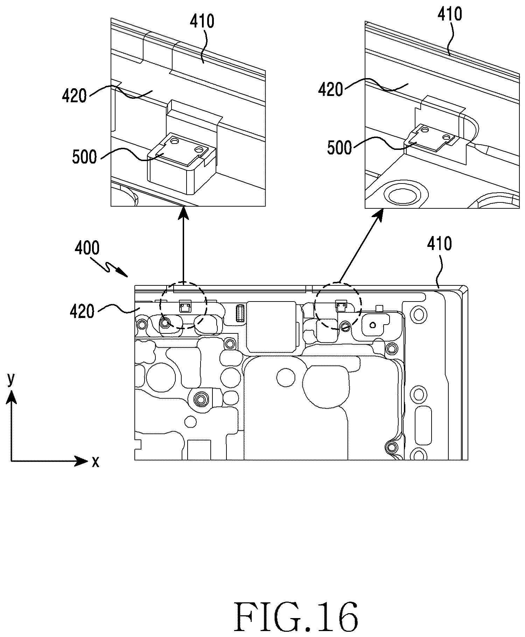

FIG. 16 is a diagram illustrating examples of shaping and coupling a conductive member and a nonconductive member according to an embodiment.

According to an embodiment of the disclosure, the protrusion 510 of the conductive member 410 projecting toward the internal space of the electronic device 400 may be coupled with the nonconductive member 420. For example, the nonconductive member 420 may include the opening 450 into which the protrusion 510 of the conductive member 410 may be inserted. For example, at least one of an area, a height, or a shape of the opening 450 of the nonconductive member 420 may be formed differently depending on the position for arranging the feeding structure in the electronic device 400.

According to an embodiment of the disclosure, the protrusion 510 of the conductive member 410 may be seated on the first recess 520 of the nonconductive member 420 through the opening 450 of the nonconductive member 420. For example, at least one of the area of the first recess 520 of the nonconductive member 420 contacting the fifth face 580 of the protrusion 510 of the conductive member 410, the distance of the second face 560 of the nonconductive member 420 extending from the first recess 520 from the fourth face 570 of the nonconductive member 420 facing the display 540, or the step of the first recess 520 may be formed differently depending on the position for arranging the feeding structure in the electronic device 400.

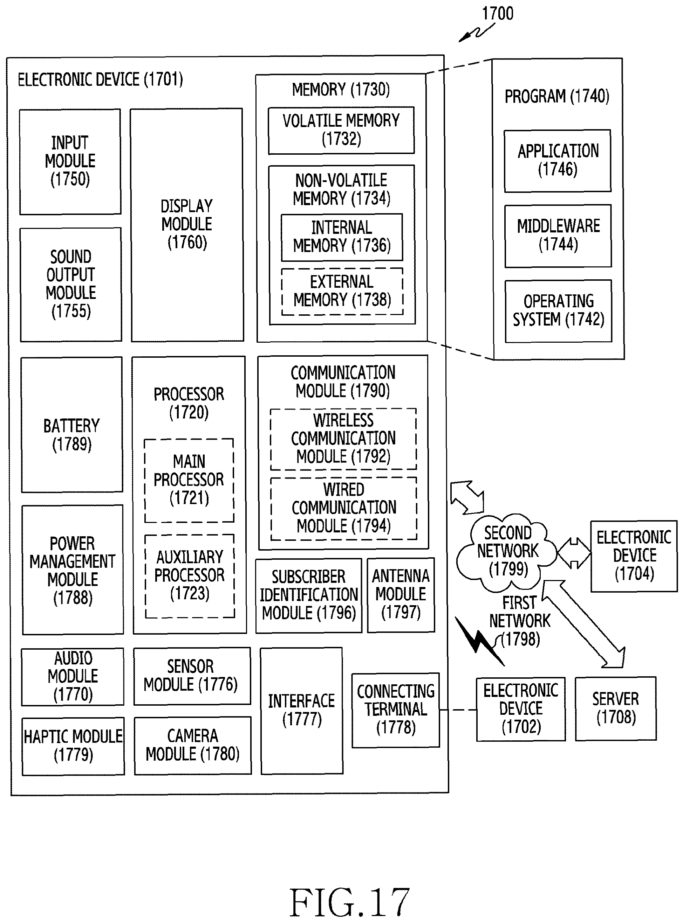

Fig. 17 is a block diagram illustrating an electronic device 1701 in a network environment 1700 according to various embodiments. Referring to Fig. 17, the electronic device 1701 in the network environment 1700 may communicate with an electronic device 1702 via a first network 1798 (e.g., a short-range wireless communication network), or at least one of an electronic device 1704 or a server 1708 via a second network 1799 (e.g., a long-range wireless communication network). According to an embodiment, the electronic device 1701 may communicate with the electronic device 1704 via the server 1708. According to an embodiment, the electronic device 1701 may include a processor 1720, memory 1730, an input module 1750, a sound output module 1755, a display module 1760, an audio module 1770, a sensor module 1776, an interface 1777, a connecting terminal 1778, a haptic module 1779, a camera module 1780, a power management module 1788, a battery 1789, a communication module 1790, a subscriber identification module(SIM) 1796, or an antenna module 1797. In some embodiments, at least one of the components (e.g., the connecting terminal 1778) may be omitted from the electronic device 1701, or one or more other components may be added in the electronic device 1701. In some embodiments, some of the components (e.g., the sensor module 1776, the camera module 1780, or the antenna module 1797) may be implemented as a single component (e.g., the display module 1760).

The processor 1720 may execute, for example, software (e.g., a program 1740) to control at least one other component (e.g., a hardware or software component) of the electronic device 1701 coupled with the processor 1720, and may perform various data processing or computation. According to one embodiment, as at least part of the data processing or computation, the processor 1720 may store a command or data received from another component (e.g., the sensor module 1776 or the communication module 1790) in volatile memory 1732, process the command or the data stored in the volatile memory 1732, and store resulting data in non-volatile memory 1734. According to an embodiment, the processor 1720 may include a main processor 1721 (e.g., a central processing unit (CPU) or an application processor (AP)), or an auxiliary processor 1723 (e.g., a graphics processing unit (GPU), a neural processing unit (NPU), an image signal processor (ISP), a sensor hub processor, or a communication processor (CP)) that is operable independently from, or in conjunction with, the main processor 1721. For example, when the electronic device 1701 includes the main processor 1721 and the auxiliary processor 1723, the auxiliary processor 1723 may be adapted to consume less power than the main processor 1721, or to be specific to a specified function. The auxiliary processor 1723 may be implemented as separate from, or as part of the main processor 1721.

The auxiliary processor 1723 may control at least some of functions or states related to at least one component (e.g., the display module 1760, the sensor module 1776, or the communication module 1790) among the components of the electronic device 1701, instead of the main processor 1721 while the main processor 1721 is in an inactive (e.g., sleep) state, or together with the main processor 1721 while the main processor 1721 is in an active state (e.g., executing an application). According to an embodiment, the auxiliary processor 1723 (e.g., an image signal processor or a communication processor) may be implemented as part of another component (e.g., the camera module 1780 or the communication module 1790) functionally related to the auxiliary processor 1723. According to an embodiment, the auxiliary processor 1723 (e.g., the neural processing unit) may include a hardware structure specified for artificial intelligence model processing. An artificial intelligence model may be generated by machine learning. Such learning may be performed, e.g., by the electronic device 1701 where the artificial intelligence is performed or via a separate server (e.g., the server 1708). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 1730 may store various data used by at least one component (e.g., the processor 1720 or the sensor module 1776) of the electronic device 1701. The various data may include, for example, software (e.g., the program 1740) and input data or output data for a command related thererto. The memory 1730 may include the volatile memory 1732 or the non-volatile memory 1734.

The program 1740 may be stored in the memory 1730 as software, and may include, for example, an operating system (OS) 1742, middleware 1744, or an application 1746.

The input module 1750 may receive a command or data to be used by another component (e.g., the processor 1720) of the electronic device 1701, from the outside (e.g., a user) of the electronic device 1701. The input module 1750 may include, for example, a microphone, a mouse, a keyboard, a key (e.g., a button), or a digital pen (e.g., a stylus pen).

The sound output module 1755 may output sound signals to the outside of the electronic device 1701. The sound output module 1755 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 1760 may visually provide information to the outside (e.g., a user) of the electronic device 1701. The display module 1760 may include, for example, a display, a hologram device, or a projector and control circuitry to control a corresponding one of the display, hologram device, and projector. According to an embodiment, the display module 1760 may include a touch sensor adapted to detect a touch, or a pressure sensor adapted to measure the intensity of force incurred by the touch.

The audio module 1770 may convert a sound into an electrical signal and vice versa. According to an embodiment, the audio module 1770 may obtain the sound via the input module 1750, or output the sound via the sound output module 1755 or a headphone of an external electronic device (e.g., an electronic device 1702) directly (e.g., wiredly) or wirelessly coupled with the electronic device 1701.

The sensor module 1776 may detect an operational state (e.g., power or temperature) of the electronic device 1701 or an environmental state (e.g., a state of a user) external to the electronic device 1701, and then generate an electrical signal or data value corresponding to the detected state. According to an embodiment, the sensor module 1776 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 1777 may support one or more specified protocols to be used for the electronic device 1701 to be coupled with the external electronic device (e.g., the electronic device 1702) directly (e.g., wiredly) or wirelessly. According to an embodiment, the interface 1777 may include, for example, a high definition multimedia interface (HDMI), a universal serial bus (USB) interface, a secure digital (SD) card interface, or an audio interface.

A connecting terminal 1778 may include a connector via which the electronic device 1701 may be physically connected with the external electronic device (e.g., the electronic device 1702). According to an embodiment, the connecting terminal 1778 may include, for example, a HDMI connector, a USB connector, a SD card connector, or an audio connector (e.g., a headphone connector).

The haptic module 1779 may convert an electrical signal into a mechanical stimulus (e.g., a vibration or a movement) or electrical stimulus which may be recognized by a user via his tactile sensation or kinesthetic sensation. According to an embodiment, the haptic module 1779 may include, for example, a motor, a piezoelectric element, or an electric stimulator.

The camera module 1780 may capture a still image or moving images. According to an embodiment, the camera module 1780 may include one or more lenses, image sensors, image signal processors, or flashes.

The power management module 1788 may manage power supplied to the electronic device 1701. According to one embodiment, the power management module 1788 may be implemented as at least part of, for example, a power management integrated circuit (PMIC).

The battery 1789 may supply power to at least one component of the electronic device 1701. According to an embodiment, the battery 1789 may include, for example, a primary cell which is not rechargeable, a secondary cell which is rechargeable, or a fuel cell.

The communication module 1790 may support establishing a direct (e.g., wired) communication channel or a wireless communication channel between the electronic device 1701 and the external electronic device (e.g., the electronic device 1702, the electronic device 1704, or the server 1708) and performing communication via the established communication channel. The communication module 1790 may include one or more communication processors that are operable independently from the processor 1720 (e.g., the application processor (AP)) and supports a direct (e.g., wired) communication or a wireless communication. According to an embodiment, the communication module 1790 may include a wireless communication module 1792 (e.g., a cellular communication module, a short-range wireless communication module, or a global navigation satellite system (GNSS) communication module) or a wired communication module 1794 (e.g., a local area network (LAN) communication module or a power line communication (PLC) module). A corresponding one of these communication modules may communicate with the external electronic device via the first network 1798 (e.g., a short-range communication network, such as BluetoothTM, wireless-fidelity (Wi-Fi) direct, or infrared data association (IrDA)) or the second network 1799 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 1792 may identify and authenticate the electronic device 1701 in a communication network, such as the first network 1798 or the second network 1799, using subscriber information (e.g., international mobile subscriber identity (IMSI)) stored in the subscriber identification module 1796.

The wireless communication module 1792 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 1792 may support a high-frequency band (e.g., the mmWave band) to achieve, e.g., a high data transmission rate. The wireless communication module 1792 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 1792 may support various requirements specified in the electronic device 1701, an external electronic device (e.g., the electronic device 1704), or a network system (e.g., the second network 1799). According to an embodiment, the wireless communication module 1792 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 1797 may transmit or receive a signal or power to or from the outside (e.g., the external electronic device) of the electronic device 1701. According to an embodiment, the antenna module 1797 may include an antenna including a radiating element composed of a conductive material or a conductive pattern formed in or on a substrate (e.g., a printed circuit board (PCB)). According to an embodiment, the antenna module 1797 may include a plurality of antennas (e.g., array antennas). In such a case, at least one antenna appropriate for a communication scheme used in the communication network, such as the first network 1798 or the second network 1799, may be selected, for example, by the communication module 1790 (e.g., the wireless communication module 1792) from the plurality of antennas. The signal or the power may then be transmitted or received between the communication module 1790 and the external electronic device via the selected at least one antenna. According to an embodiment, another component (e.g., a radio frequency integrated circuit (RFIC)) other than the radiating element may be additionally formed as part of the antenna module 1797.

According to various embodiments, the antenna module 1797 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 1701 and the external electronic device 1704 via the server 1708 coupled with the second network 1799. Each of the electronic devices 1702 or 1704 may be a device of a same type as, or a different type, from the electronic device 1701. According to an embodiment, all or some of operations to be executed at the electronic device 1701 may be executed at one or more of the external electronic devices 1702, 1704, or 1708. For example, if the electronic device 1701 should perform a function or a service automatically, or in response to a request from a user or another device, the electronic device 1701, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 1701. The electronic device 1701 may provide the outcome, with or without further processing of the outcome, as at least part of a reply to the request. To that end, a cloud computing, distributed computing, mobile edge computing (MEC), or client-server computing technology may be used, for example. The electronic device 1701 may provide ultra low-latency services using, e.g., distributed computing or mobile edge computing. In another embodiment, the external electronic device 1704 may include an internet-of-things (IoT) device. The server 1708 may be an intelligent server using machine learning and/or a neural network. According to an embodiment, the external electronic device 1704 or the server 1708 may be included in the second network 1799. The electronic device 1701 may be applied to intelligent services (e.g., smart home, smart city, smart car, or healthcare) based on 5G communication technology or IoT-related technology.

Problems to be solved according to an embodiment of the disclosure may be as follows.

According to an embodiment of the disclosure, an electronic device may provide a printed circuit board including a wireless communication circuit for feeding a radio signal through a conductive connection member to a conductive member spaced apart from a display over at least a specific distance.

According to an embodiment of the disclosure, an electronic device may provide a welding sheet which is welded to at least a part of a conductive member parallel to a printed circuit board.

According to an embodiment of the disclosure, an electronic device (e.g., the electronic device 200 of FIG. 1, the electronic device 400 of FIG. 4A) may include a conductive member (e.g., the conductive portion 2181 of FIG. 1, the conductive member 410 of FIG. 4B) for forming at least a part of a lateral face of the electronic device (e.g., the electronic device 200 of FIG. 1, the electronic device 400 of FIG. 4A) and radiating a signal of a designated frequency band. The conductive member (e.g., the conductive portion 2181 of FIG. 1, the conductive member 410 of FIG. 4B) may include a protrusion (e.g., the protrusion 510 of FIG. 4A) which projects toward an internal space of the electronic device (e.g., the electronic device 200 of FIG. 1, the electronic device 400 of FIG. 4A). The electronic device (e.g., the electronic device 200 of FIG. 1, the electronic device 400 of FIG. 4A) may include a display (e.g., the display 201 of FIG. 1, the display 540 of FIG. 4B) disposed on at least a part of a front face of the electronic device (e.g., the electronic device 200 of FIG. 1, the electronic device 400 of FIG. 4A). The electronic device (e.g., the electronic device 200 of FIG. 1, the electronic device 400 of FIG. 4A) may include a nonconductive member (e.g., the nonconductive portions 2182 and 2183 of FIG. 1, the nonconductive member 420 of FIG. 4B) disposed between a rear face of the electronic device (e.g., the electronic device 200 of FIG. 1, the electronic device 400 of FIG. 4A) and the display (e.g., the display 201 of FIG. 1, the display 540 of FIG. 4B) and coupled with the conductive member (e.g., the conductive portion 2181 of FIG. 1, the conductive member 410 of FIG. 4B). The electronic device (e.g., the electronic device 200 of FIG. 1, the electronic device 400 of FIG. 4A) may include a printed circuit board (e.g., the printed circuit board 430 of FIG. 7) disposed in the internal space of the electronic device (e.g., the electronic device 200 of FIG. 1, the electronic device 400 of FIG. 4A). The electronic device (e.g., the electronic device 200 of FIG. 1, the electronic device 400 of FIG. 4A) may include a wireless communication circuit disposed on the printed circuit board (e.g., the printed circuit board 430 of FIG. 7). The nonconductive member (e.g., the nonconductive portions 2182 and 2183 of FIG. 1, the nonconductive member 420 of FIG. 4B) may include a first recess (e.g., the first recess 520 of FIG. 4B) onto which the protrusion (e.g., the protrusion 510 of FIG. 4A) of the conductive member (e.g., the conductive portion 2181 of FIG. 1, the conductive member 410 of FIG. 4B) is seated. Since the wireless communication circuit feeds the conductive member (e.g., the conductive portion 2181 of FIG. 1, the conductive member 410 of FIG. 4B) through at least part of a third face (e.g., the third face 515 of FIG. 4B) formed by a first face (e.g., the first face 550 of FIG. 4B) of the protrusion (e.g., the protrusion 510 of FIG. 4A) of the conductive member (e.g., the conductive portion 2181 of FIG. 1, the conductive member 410 of FIG. 4B) and a second face (e.g., the second face 560 of FIG. 4B) extending from the first recess (e.g., the first recess 520 of FIG. 4B) of the nonconductive member (e.g., the nonconductive portions 2182 and 2183 of FIG. 1, the nonconductive member 420 of FIG. 4B), the signal of the designated frequency band may be radiated from the conductive member (e.g., the conductive portion 2181 of FIG. 1, the conductive member 410 of FIG. 4B).

According to an embodiment of the disclosure, the first face (e.g., the first face 550 of FIG. 4B) of the protrusion (e.g., the protrusion 510 of FIG. 4A) of the conductive member (e.g., the conductive portion 2181 of FIG. 1, the conductive member 410 of FIG. 4B) may form the third face (e.g., the third face 515 of FIG. 4B) by connecting to the second face (e.g., the second face 560 of FIG. 4B) of the nonconductive member (e.g., the nonconductive portions 2182 and 2183 of FIG. 1, the nonconductive member 420 of FIG. 4B) to form one face.

According to an embodiment of the disclosure, the electronic device (e.g., the electronic device 200 of FIG. 1, the electronic device 400 of FIG. 4A) may further include a conductive connection member (e.g., the conductive connection member 440 of FIG. 7) for electrically connecting the wireless communication circuit and the conductive member (e.g., the conductive portion 2181 of FIG. 1, the conductive member 410 of FIG. 4B). The electronic device (e.g., the electronic device 200 of FIG. 1, the electronic device 400 of FIG. 4A) may further include a conductive sheet (e.g., the conductive sheet 500 of FIG. 5) disposed on at least a part of the first face (e.g., the first face 550 of FIG. 4B) of the protrusion (e.g., the protrusion 510 of FIG. 4A) of the conductive member (e.g., the conductive portion 2181 of FIG. 1, the conductive member 410 of FIG. 4B) and the second face (e.g., the second face 560 of FIG. 4B) of the nonconductive member (e.g., the nonconductive portions 2182 and 2183 of FIG. 1, the nonconductive member 420 of FIG. 4B). Since the conductive connection member (e.g., the conductive connection member 440 of FIG. 7) is electrically connected to the conductive sheet (e.g., the conductive sheet 500 of FIG. 5), the wireless communication circuit may feed to the conductive member (e.g., the conductive portion 2181 of FIG. 1, the conductive member 410 of FIG. 4B).

According to an embodiment of the disclosure, the conductive sheet (e.g., the conductive sheet 500 of FIG. 5) may include a first portion (e.g., the first portion 610 of FIG. 5) electrically connected to at least a part of the first face (e.g., the first face 550 of FIG. 4B) of the protrusion (e.g., the protrusion 510 of FIG. 4A) of the conductive member (e.g., the conductive portion 2181 of FIG. 1, the conductive member 410 of FIG. 4B) and a second portion (e.g., the second portion 620 of FIG. 5) attached to at least a part of the second face (e.g., the second face 560 of FIG. 4B) of the nonconductive member (e.g., the nonconductive portions 2182 and 2183 of FIG. 1, the nonconductive member 420 of FIG. 4B).

According to an embodiment of the disclosure, the first portion (e.g., the first portion 610 of FIG. 5) of the conductive sheet (e.g., the conductive sheet 500 of FIG. 5) may be attached by welding to at least a part of the first face (e.g., the first face 550 of FIG. 4B) of the protrusion (e.g., the protrusion 510 of FIG. 4A) of the conductive member (e.g., the conductive portion 2181 of FIG. 1, the conductive member 410 of FIG. 4B). The second portion (e.g., the second portion 620 of FIG. 5) of the conductive sheet (e.g., the conductive sheet 500 of FIG. 5) may be attached by an adhesive member to at least a part of the second face (e.g., the second face 560 of FIG. 4B) of the nonconductive member (e.g., the nonconductive portions 2182 and 2183 of FIG. 1, the nonconductive member 420 of FIG. 4B).

According to an embodiment of the disclosure, the first portion (e.g., the first portion 610 of FIG. 5) of the conductive sheet (e.g., the conductive sheet 500 of FIG. 5) may include a plurality of openings (e.g., the opening 710 of FIG. 6) welded to at least a part of the first face (e.g., the first face 550 of FIG. 4B) of the protrusion (e.g., the protrusion 510 of FIG. 4A) of the conductive member (e.g., the conductive portion 2181 of FIG. 1, the conductive member 410 of FIG. 4B). The second portion (e.g., the second portion 620 of FIG. 5) of the conductive sheet (e.g., the conductive sheet 500 of FIG. 5) may be attached by a tape to at least a part of the second face (e.g., the second face 560 of FIG. 4B) of the nonconductive member (e.g., the nonconductive portions 2182 and 2183 of FIG. 1, the nonconductive member 420 of FIG. 4B).

According to an embodiment of the disclosure, a width of the first portion (e.g., the first portion 610 of FIG. 5) of the conductive sheet (e.g., the conductive sheet 500 of FIG. 5) may be greater than a width of the second portion (e.g., the second portion 620 of FIG. 5) of the conductive sheet (e.g., the conductive sheet 500 of FIG. 5).

According to an embodiment of the disclosure, a length of the first portion (e.g., the first portion 610 of FIG. 5) of the conductive sheet (e.g., the conductive sheet 500 of FIG. 5) may be smaller than a length of the second portion (e.g., the second portion 620 of FIG. 5) of the conductive sheet (e.g., the conductive sheet 500 of FIG. 5).

According to an embodiment of the disclosure, one end of the conductive connection member (e.g., the conductive connection member 440 of FIG. 7) may be electrically connected to the conductive sheet (e.g., the conductive sheet 500 of FIG. 5). The other end of the conductive connection member (e.g., the conductive connection member 440 of FIG. 7) may be connected to the wireless communication circuit on the printed circuit board (e.g., the printed circuit board 430 of FIG. 7).

According to an embodiment of the disclosure, the nonconductive member (e.g., the nonconductive portions 2182 and 2183 of FIG. 1, the nonconductive member 420 of FIG. 4B) may include a fourth face (e.g., the fourth face 570 of FIG. 4B) facing the display (e.g., the display 201 of FIG. 1, the display 540 of FIG. 4B) and opposite to the second face (e.g., the second face 560 of FIG. 4B) of the nonconductive member (e.g., the nonconductive portions 2182 and 2183 of FIG. 1, the nonconductive member 420 of FIG. 4B). The protrusion (e.g., the protrusion 510 of FIG. 4A) of the conductive member (e.g., the conductive portion 2181 of FIG. 1, the conductive member 410 of FIG. 4B) may include a fifth face (e.g., the fifth face 580 of FIG. 4B) contacting the first recess (e.g., the first recess 520 of FIG. 4B) and opposite to the first face (e.g., the first face 550 of FIG. 4B) of the conductive member (e.g., the conductive portion 2181 of FIG. 1, the conductive member 410 of FIG. 4B). A distance between the second face (e.g., the second face 560 of FIG. 4B) and the fourth face (e.g., the fourth face 570 of FIG. 4B) may be greater than a distance between the fifth face (e.g., the fifth face 580 of FIG. 4B) and the fourth face (e.g., the fourth face 570 of FIG. 4B).

According to an embodiment of the disclosure, the nonconductive member (e.g., the nonconductive portions 2182 and 2183 of FIG. 1, the nonconductive member 420 of FIG. 4B) may include a second recess (e.g., the second recess 530 of FIG. 4B) which forms a step with the first recess (e.g., the first recess 520 of FIG. 4B). A portion adjacent to the protrusion (e.g., the protrusion 510 of FIG. 4A) of the conductive member (e.g., the conductive portion 2181 of FIG. 1, the conductive member 410 of FIG. 4B) may seat on the second recess (e.g., the second recess 530 of FIG. 4B).

According to an embodiment of the disclosure, the protrusion (e.g., the protrusion 510 of FIG. 4A) of the conductive member (e.g., the conductive portion 2181 of FIG. 1, the conductive member 410 of FIG. 4B) may project perpendicular to the lateral face of the electronic device (e.g., the electronic device 200 of FIG. 1, the electronic device 400 of FIG. 4A) toward the internal space of the electronic device (e.g., the electronic device 200 of FIG. 1, the electronic device 400 of FIG. 4A).

According to an embodiment of the disclosure, the third face (e.g., the third face 515 of FIG. 4B) may be formed parallel to one face of the printed circuit board (e.g., the printed circuit board 430 of FIG. 7) on which the wireless communication circuit is disposed.

According to an embodiment of the disclosure, the printed circuit board (e.g., the printed circuit board 430 of FIG. 7) may overlap at least in part the protrusion (e.g., the protrusion 510 of FIG. 4B), when viewing the conductive member (e.g., the conductive portion 2181 of FIG. 1, the conductive member 410 of FIG. 4B) from the lateral face of the electronic device (e.g., the electronic device 200 of FIG. 1, the electronic device 400 of FIG. 4A). The conductive connection member (e.g., the conductive connection member of FIG. 7) may electrically connect a face of the printed circuit board (e.g., the printed circuit board 430 of FIG. 7) facing the rear face of the electronic device (e.g., the electronic device 200 of FIG. 1, the electronic device 400 of FIG. 4A) with the conductive sheet (e.g., the conductive sheet 500 of FIG. 5).

According to an embodiment of the disclosure, the printed circuit board (e.g., the printed circuit board 430 of FIG. 7) may overlap at least in part the protrusion (e.g., the protrusion 510 of FIG. 4B), when viewing the protrusion (e.g., the protrusion 510 of FIG. 4B) from the front face of the electronic device (e.g., the electronic device 200 of FIG. 1, the electronic device 400 of FIG. 4A).

According to an embodiment of the disclosure, the conductive connection member (e.g., the conductive connection member 440 of FIG. 7) may electrically connect a face of the printed circuit board (e.g., the printed circuit board 430 of FIG. 7) facing the front face of the electronic device (e.g., the electronic device 200 of FIG. 1, the electronic device 400 of FIG. 4A) with the conductive sheet (e.g., the conductive sheet 500 of FIG. 5).

According to an embodiment of the disclosure, the conductive connection member (e.g., the conductive connection member 440 of FIG. 7) may electrically connect at least one of faces of the printed circuit board (e.g., the printed circuit board 430 of FIG. 7) facing the rear face of the electronic device (e.g., the electronic device 200 of FIG. 1, the electronic device 400 of FIG. 4A) with the conductive sheet (e.g., the conductive sheet 500 of FIG. 5).

According to an embodiment of the disclosure, the protrusion (e.g., the protrusion 510 of FIG. 4A) of the conductive member (e.g., the conductive portion 2181 of FIG. 1, the conductive member 410 of FIG. 4B) may be coupled with the nonconductive member (e.g., the nonconductive portions 2182 and 2183 of FIG. 1, the nonconductive member 420 of FIG. 4B) through an opening (e.g., the opening 450 of FIG. 4A) of the nonconductive member (e.g., the nonconductive portions 2182 and 2183 of FIG. 1, the nonconductive member 420 of FIG. 4B). The protrusion (e.g., the protrusion 510 of FIG. 4A) of the conductive member (e.g., the conductive portion 2181 of FIG. 1, the conductive member 410 of FIG. 4B) may seat on the first recess (e.g., the first recess 520 of FIG. 4B) of the nonconductive member (e.g., the nonconductive portions 2182 and 2183 of FIG. 1, the nonconductive member 420 of FIG. 4B) adjacent to the opening (e.g., the opening 450 of FIG. 4A) of the nonconductive member (e.g., the nonconductive portions 2182 and 2183 of FIG. 1, the nonconductive member 420 of FIG. 4B).

An electronic device (e.g., the electronic device 200 of FIG. 1, the electronic device 400 of FIG. 4A) according to an embodiment of the disclosure may include a conductive member (e.g., the conductive portion 2181 of FIG. 1, the conductive member 410 of FIG. 4B) for forming at least a part of a lateral face of the electronic device (e.g., the electronic device 200 of FIG. 1, the electronic device 400 of FIG. 4A) and radiating a signal of a designated frequency band. The conductive member (e.g., the conductive portion 2181 of FIG. 1, the conductive member 410 of FIG. 4B) may include a protrusion (e.g., the protrusion 510 of FIG. 4A) which projects toward an internal space of the electronic device (e.g., the electronic device 200 of FIG. 1, the electronic device 400 of FIG. 4A). The electronic device (e.g., the electronic device 200 of FIG. 1, the electronic device 400 of FIG. 4A) may include a nonconductive member (e.g., the nonconductive portions 2182 and 2183 of FIG. 1, the nonconductive member 420 of FIG. 4B) disposed between a front face of the electronic device (e.g., the electronic device 200 of FIG. 1, the electronic device 400 of FIG. 4A) and a rear face of the electronic device (e.g., the electronic device 200 of FIG. 1, the electronic device 400 of FIG. 4A) and coupled with the conductive member (e.g., the conductive portion 2181 of FIG. 1, the conductive member 410 of FIG. 4B) to secure the conductive member (e.g., the conductive portion 2181 of FIG. 1, the conductive member 410 of FIG. 4B). The electronic device (e.g., the electronic device 200 of FIG. 1, the electronic device 400 of FIG. 4A) may include a printed circuit board (e.g., the printed circuit board 440 of FIG. 7) including a wireless communication circuit which feeds the conductive member (e.g., the conductive portion 2181 of FIG. 1, the conductive member 410 of FIG. 4B). The electronic device (e.g., the electronic device 200 of FIG. 1, the electronic device 400 of FIG. 4A) may include a memory for storing instructions. The electronic device (e.g., the electronic device 200 of FIG. 1, the electronic device 400 of FIG. 4A) may include one or more processors. The nonconductive member (e.g., the nonconductive portions 2182 and 2183 of FIG. 1, the nonconductive member 420 of FIG. 4B) may include a first recess (e.g., the first recess 520 of FIG. 4B) onto which the protrusion (e.g., the protrusion 510 of FIG. 4A) of the conductive member (e.g., the conductive portion 2181 of FIG. 1, the conductive member 410 of FIG. 4B) is seated. The instructions may, when executed by the one or more processors, cause the electronic device (e.g., the electronic device 200 of FIG. 1, the electronic device 400 of FIG. 4A) to feed, at the wireless communication circuit, to the conductive member (e.g., the conductive portion 2181 of FIG. 1, the conductive member 410 of FIG. 4B) through a conductive sheet (e.g., the conductive sheet 500 of FIG. 5) disposed on one face formed by the protrusion (e.g., the protrusion 510 of FIG. 4A) of the conductive member (e.g., the conductive portion 2181 of FIG. 1, the conductive member 410 of FIG. 4B) and a peripheral portion of the first recess (e.g., the first recess 520 of FIG. 4B) of the nonconductive member (e.g., the nonconductive portions 2182 and 2183 of FIG. 1, the nonconductive member 420 of FIG. 4B).

The conductive sheet (e.g., the conductive sheet 500 of FIG. 5) according to an embodiment of the disclosure may include a first portion (e.g., the first portion 610 of FIG. 5) electrically connected to at least a part of the protrusion (e.g., the protrusion 510 of FIG. 4A) of the conductive member (e.g., the conductive portion 2181 of FIG. 1, the conductive member 410 of FIG. 4B) and a second portion (e.g., the second portion 620 of FIG. 5) attached to at least a part of the peripheral region of the nonconductive member (e.g., the nonconductive portions 2182 and 2183 of FIG. 1, the nonconductive member 420 of FIG. 4B).

Effects of the invention according to an embodiment of the disclosure are as follows.

According to an embodiment of the disclosure, the electronic device may provide the feeding structure in which a radio signal is affected less by the display, by feeding the radio signal to the protrusion of the conductive member spaced from the display over at least a specific distance.

According to an embodiment of the disclosure, the electronic device may provide the feeding structure for facilitating the welding, by welding the conductive sheet onto one face formed by the conductive member and the nonconductive member.

Besides, various effects obtained directly or indirectly from the disclosure may be provided.

The methods according to the embodiments described in the claims or the specification of the disclosure may be implemented in software, hardware, or a combination of hardware and software.

In software implementation, a computer-readable storage medium storing one or more programs (software modules) may be provided. One or more programs stored in the computer-readable storage medium may be configured for execution by one or more processors of an electronic device. One or more programs may include instructions for controlling an electronic device to execute the methods according to the embodiments described in the claims or the specification of the disclosure.

Such a program (software module, software) may be stored to a random access memory, a non-volatile memory including a flash memory, a read only memory (ROM), an electrically erasable programmable ROM (EEPROM), a magnetic disc storage device, a CD-ROM, digital versatile discs (DVDs) or other optical storage devices, and a magnetic cassette. Alternatively, it may be stored to a memory combining part or all of them. In addition, a plurality of memories may be included.

Also, the program may be stored in an attachable storage device accessible via a communication network such as internet, intranet, local area network (LAN), wide LAN (WLAN), or storage area network (SAN), or a communication network by combining these networks. Such a storage device may access a device which executes an embodiment of the disclosure through an external port. In addition, a separate storage device on the communication network may access the device which executes an embodiment of the disclosure.

In the specific embodiments of the disclosure, the component included in the disclosure is expressed in a singular or plural form. However, the singular or plural expression is appropriately selected according to a proposed situation for the convenience of explanation, the disclosure is not limited to a single component or a plurality of components, the components expressed in the plural form may be configured as a single component, and the components expressed in the singular form may be configured as a plurality of components.

In addition, a term such as "unit" or "module" in the disclosure may be a hardware component such as a processor or a circuit, and/or a software component executed by a hardware component such as a processor.

"unit" and "module" may be stored in an addressable storage medium and implemented by a program executable by the processor. For example, "unit" and "module" may be implemented by components such as software components, object-oriented software components, class components and task components, processes, functions, attributes, procedures, sub-routines, segments of program code, drivers, firmware, microcode, circuit, data, databases, data structures, tables, arrays and variables.

Specific implementations described in this disclosure are merely embodiments, and are not intended to limit the scope of the disclosure in any way. For the sake of brevity of the specification, disclosure of conventional electronic configurations, control systems, software, and other functional aspects of the systems may be omitted.

In addition, in the disclosure, "including at least one of a, b, or c" may indicate "including a alone, including b alone, including c alone, including a and b, including b and c, including a and c, or including all of a, b, and c".

Meanwhile, while the specific embodiment has been described in the detailed explanation of the disclosure, it will be noted that various modifications may be made without departing from the scope of the disclosure. Therefore, the scope of the disclosure is not limited and defined by the described embodiment and is defined by not only the scope of the claims as below but also their equivalents.

## Claims

1. An electronic device comprising:
a conductive member forming at least a part of a lateral face of the electronic device and radiating a signal of a designated frequency band, the conductive member comprising a protrusion which projects toward an internal space of the electronic device;
a display disposed on at least a part of a front face of the electronic device;
a nonconductive member disposed between a rear face of the electronic device and the display and coupled to the conductive member;
a printed circuit board disposed in the internal space of the electronic device; and
a wireless communication circuit disposed on the printed circuit board,
wherein the nonconductive member comprises a first recess onto which the protrusion of the conductive member is seated, and
the wireless communication circuit is configured to feed the conductive member through at least part of a third face formed by a first face of the protrusion of the conductive member and a second face extending from the first recess of the nonconductive member, to radiate the signal of the designated frequency band from the conductive member.

2. The electronic device of claim 1, wherein the first face of the protrusion of the conductive member connects to the second face of the nonconductive member to form the third face as a single face.

3. The electronic device of claim 1, further comprising:
a conductive connection member for electrically connecting the wireless communication circuit and the conductive member; and
a conductive sheet disposed on at least a part of the first face of the protrusion of the conductive member and the second face of the nonconductive member,
wherein the conductive connection member is electrically connected to the conductive sheet, such that the wireless communication circuit feeds the conductive member.

4. The electronic device of claim 3, wherein the conductive sheet comprises a first portion electrically connected to at least a part of the first face of the protrusion of the conductive member and a second portion attached to at least a part of the second face of the nonconductive member.

5. The electronic device of claim 4, wherein the first portion of the conductive sheet is attached by welding to at least a part of the first face of the protrusion of the conductive member, and
the second portion of the conductive sheet is attached by an adhesive member to at least a part of the second face of the nonconductive member.

6. The electronic device of claim 5, wherein the first portion of the conductive sheet comprises a plurality of openings welded to at least a part of the first face of the protrusion of the conductive member, and
the adhesive member comprises an adhesive tape.

7. The electronic device of claim 4, wherein a width of the first portion of the conductive sheet is greater than a width of the second portion of the conductive sheet, and
wherein a length of the first portion of the conductive sheet is smaller than a length of the second portion of the conductive sheet.

8. The electronic device of claim 3, wherein one end of the conductive connection member is electrically connected to the conductive sheet, and the other end of the conductive connection member is connected to the wireless communication circuit on the printed circuit board.

9. The electronic device of claim 1, wherein the nonconductive member comprises a fourth face facing the display and opposite to the second face of the nonconductive member,
the protrusion of the conductive member comprises a fifth face contacting the first recess and opposite to the first face of the conductive member, and
the distance between the second face and the fourth face is greater than the distance between the fifth face and the fourth face.

10. The electronic device of claim 1, wherein the nonconductive member comprises a second recess which forms a step with the first recess, and
a portion adjacent to the protrusion of the conductive member is seated on the second recess.

11. The electronic device of claim 1, wherein the protrusion of the conductive member extends perpendicular to the lateral face of the electronic device toward the internal space of the electronic device.

12. The electronic device of claim 1, wherein the third face is formed parallel to one face of the printed circuit board on which the wireless communication circuit is disposed.

13. The electronic device of claim 3, wherein the printed circuit board overlaps the protrusion at least in part, when viewing the conductive member from the lateral face of the electronic device, and
the conductive connection member electrically connects a face of the printed circuit board facing the rear face of the electronic device with the conductive sheet.

14. The electronic device of claim 3, wherein the printed circuit board overlaps the protrusion at least in part, when viewing the protrusion from the front face of the electronic device,
wherein the conductive connection member electrically connects a face of the printed circuit board facing the front face of the electronic device with the conductive sheet, or
wherein the conductive connection member electrically connects a face of the printed circuit board facing the rear face of the electronic device with the conductive sheet.

15. An electronic device comprising:
a conductive member for forming at least a part of a lateral face of the electronic device and radiating a signal of a designated frequency band, the conductive member comprising a protrusion which projects toward an internal space of the electronic device;
a nonconductive member disposed between a front face of the electronic device and a rear face of the electronic device and coupled with the conductive member to secure the conductive member;
a printed circuit board comprising a wireless communication circuit which feeds the conductive member;
a memory for storing instructions; and
one or more processors,
wherein the nonconductive member comprises a first recess onto which the protrusion of the conductive member is seated, and
the instructions, when executed by the one or more processors, cause the electronic device to:
feed, at the wireless communication circuit, to the conductive member through a conductive sheet disposed on one face formed by the protrusion of the conductive member and a peripheral portion of the first recess of the nonconductive member.
